# EUROPÄISCHE PATENTSCHRIFT

(11) **EP 1 880 431 B1**
(45) Veröffentlichungstag und Bekanntmachung des Hinweises auf die Patenterteilung: **25.01.2012**
(21) Anmeldenummer: 06753488.3
(22) Anmeldetag: 05.05.2006
(51) Int. Cl.: H01L 51/10

(54) **Verfahren zur Ausbildung einer Verkapselung für eine Polymerhalbleiterschaltung**
Method of fabricating an encapsulation for a polymeric semiconducting circuit
Procédé d'encapsulation de circuit intégré à semi-conducteur polymérique

(30) Priorität: 09.05.2005 DE 102005022039
(43) Veröffentlichungstag der Anmeldung: 23.01.2008
(73) Patentinhaber: PolyIC GmbH & Co. KG, 90763 Fürth (DE)
(72) Erfinder: ULLMANN, Andreas, 90513 Zirndorf (DE); FIX, Walter, 90763 Fürth (DE); KNOBLOCH, Alexander, 33100 Paderborn (DE); WELKER, Merlin, 91083 Baiersdorf (DE); BREHM, Ludwig, 91325 Adelsdorf (DE); HERRMANN, Jürgen, 90766 Fürth (DE)
(74) Vertreter: Zinsinger, Norbert
(86) Internationale Anmeldenummer: PCT/EP2006/004202
(87) Internationale Veröffentlichungsnummer: WO 2006/119917

(56) Entgegenhaltungen:
- WO-A-2005/004205
- US-A- 5 965 979
- US-A1- 2003 207 488
- US-A1- 2004 026 689
- US-A1- 2004 126 935

## Beschreibung

Die Erfindung betrifft ein Verfahren zur Herstellung eines verkapselten Elektronikbauteils mit einer druckbaren Polymerhalbleiterschaltung und ein mit diesem Verfahren hergestelltes Elektronikbauteil.

Druckbare Polymerhalbleiterschaltungen werden insbesondere für im Low-Cost-Bereich angesiedelte Massenanwendungen verwendet. Solche im wesentlichen aus dünnen organischen Halbleiter- und Isolatorschichten gebildete Schaltungen müssen jedoch gegen Umwelteinflüsse, wie beispielsweise Licht, Luftsauerstoff, Feuchtigkeit, Druck, Abrieb und Handschweiß, geschützt werden.

DE 100 44 841 A1 beschreibt ein spezielles Plasmabeschichtungsverfahren zum Schutz von elektronischen und mikroelektronischen organischen Bauelementen, wie beispielsweise OLEDS. Durch intermittierendes Plasmabeschichten und Einhalten eines großen Abstandes zwischen Plasmastrahler und Bauelement wird die Oberflächenbelastung des Bauelements auf ein verträgliches Maß reduziert. Ein solches Verfahren ist für billige Massenanwendungen nicht geeignet.

Das Aufbringen von Schichten auf ein organisches Bauteil beispielsweise durch Aufrakeln einer lösungsmittelhaltigen Druckfarbe kann zur Beeinträchtigung oder zur Zerstörung des Bauteils führen. Abgesehen von den unerwünschten chemischen Wirkungen auf die Polymerhalbleiterschichten können solche Schichten so druckempfindlich sein, daß sie durch das Aufbringen der Barriereschicht beschädigt werden.

Die US 2004/126935 A1 beschreibt ein oder mehrere organische Feldeffekttransistoren, die von einer Schutzschicht bedeckt sind. Die Schutzschicht wirkt als Trägerschicht und als Schutz gegen Feuchtigkeit, Sauerstoff und Licht. Die Schutzschicht wird mittels einer beheizten Walze vollflächig auf den die organische Feldeffekttransistoren enthaltenen Mehrschichtkörper auch unter Einwirkung von Hitze und Druck auflaminiert.

Der Erfindung liegt nun die Aufgabe zugrunde, ein kostengünstiges, für die Massenproduktion geeignetes verkapseltes Elektronikbauteil mit einer druckbaren Polymerhalbleiterschaltung und ein Verfahren zur Herstellung der Verkapselung anzugeben.

Die Aufgabe der Erfindung wird gelöst durch ein Verfahren zur Ausbildung einer Verkapselung für eine auf einem Trägersubstrat angeordnete Polymerhalbleiterschaltung gemäß Anspruch 1.

Die Ausbildung der Verkapselung der gegen Umwelteinflüsse zu schützenden Polymerhalbleiterschaltung durch eine Barriereschicht aus einer Thermotransferschicht ist besonders vorteilhaft, weil die Übertragung der Thermotransferschicht ohne Verwendung von Lösungsmitteln und ohne Anwendung von Druck erfolgt. Es werden thermische Druckköpfe verwendet, wie sie für den Thermotransferdruck üblich sind. Solche Druckköpfe weisen Heizelemente auf, deren Abmessungen < 100 µm sind. Es wird also durch das Heizelement bei der Übertragung ein winziger Bereich der Thermotransferschicht aufgeschmolzen und von der Trägerfolie des Druckbandes auf die Oberfläche der Polymerhalbleiterschaltung übertragen. Auf diese Weise wird die thermische Belastung der Oberfläche der Polymerhalbleiterschaltung sehr gering gehalten und es ist kein Anpreßdruck benötigt, um das aufgeschmolzene Material der Thermotransferschicht stoffschlüssig mit der Oberfläche der Polymerhalbleiterschaltung zu verbinden. Weil das Material der Thermotransferschicht aufgeschmolzen wird, verschmelzen zwei benachbarte Punkte miteinander und bilden so eine durchgehende Barriereschicht aus, die sich ohne Faltenbildung der dem Trägersubstrat abgewandten Oberfläche der Polymerhalbleiterschaltung anschmiegt.

Probleme, wie sie beim Applizieren von Folien auftreten können, werden durch die erfindungsgemäße Verkapselung vermieden: Das erfindungsgemäße Verfahren ist so wesentlich toleranter gegenüber Verunreinigungen, wie Staub. Derartige Verunreinigungen können beim Aufbringen einer Folie hohe punktuelle Druckbelastungen auf der Polymerhalbleiterschaltung hervorrufen und diese dadurch beschädigen. Dies wird bei dem erfindungsgemäßen Verfahren vermieden, so daß für die Verkapselung von Polymerhalbleiterschaltungen nicht mehr länger Reinraumbedingungen eingehalten werden müssen.

Weitere vorteilhafte Ausgestaltungen sind in den Unteransprüchen bezeichnet.

Es kann vorgesehen sein, daß die Thermotransferschicht auf die Oberfläche der Polymerhalbleiterschaltung und mindestens auf den an die Polymerhalbleiterschaltung angrenzenden Bereich des Trägersubstrats übertragen wird. Auf diese Weise werden auch die Kanten der Polymerhalbleiterschaltung wirkungsvoll geschützt, denn die während der Übertragung aufgeschmolzene Thermotransferschicht umfließt die Kanten und gleicht so Höhenunterschiede zwischen der Oberfläche der Polymerhalbleiterschaltung und dem Trägersubstrat aus. Die Höhenunterschiede können je nach Ausbildung der Polymerhalbleiterschaltung zwischen 50 nm und 200 nm betragen.

De Thermotransferschicht kann vorteilhafterweise aus einem thermoplastischen Kunstharz gebildet sein, beispielsweise aus einem Styrolacrylat.

Weiter kann vorgesehen sein, daß für die Thermotransferschicht bzw. die Barriereschicht ein thermoplastisches Material verwendet wird, das einen Erweichungsbereich von 50 °C bis 80 °C aufweist und/oder das einen Schmelzbereich von 65 °C bis 110 °C aufweist. Die Wahl des Erweichungsbereiches oder des Schmelzbereiches kann die Übertragungsgeschwindigkeit der Thermotransferschicht beeinflussen. Es kann beispielsweise vorgesehen sein, daß Erweichungsbereich und Schmelzbereich eng beieinanderliegen, um noch im heißen Zustand die Trägerfolie ohne Qualitätseinbuße von der auf die Polymerhalbleiterschaltung übertragene Thermotransferschicht abziehen zu können.

Vorteilhafterweise ist vorgesehen, daß die Barriereschicht aus einem thermoplastischen Compound, beispielsweise einer Mischung von Wachsestern und Ethylenvinylacetat-Copolymeren, gebildet wird. Ethylenvinylacetat (EVA) zeichnet sich durch einen niedrigen Schmelzpunkt und hohe Oberflächenhärte bei gleichzeitiger Elastizität aus, kann problemlos eingefärbt werden und schützt die Polymerhalbleiterschicht zugleich vor Druckbeanspruchungen, die im Gebrauch auftreten können.

Es kann vorgesehen sein, daß die Barriereschicht in einer Dicke von 1 µm bis 10 µm ausgebildet wird.

Vorteilhafterweise kann ein Druckband verwendet werden, das zwischen der Trägerfolie und der Thermotransferschicht eine Wachsschicht aufweist, wenn vorgesehen ist, daß die Trägerfolie von der übertragenen Thermotransferschicht abgezogen wird, wenn diese noch heiß ist. Auf diese Weise ist die Haftfestigkeit der Thermotransferschicht auf der Trägerfolie wesentlich geringer als auf der Oberfläche der Polymerhalbleiterschaltung, so daß die Trägerfolie auch von der heißen Thermotransferschicht problemlos abgezogen werden kann. In diesem Fall kann die Vorschubgeschwindigkeit des Trägersubstrats ca. 300 mm/s sein.

In einer weiteren Ausführung ist vorgesehen, daß die Trägerfolie von der übertragenen Thermotransferschicht abgezogen wird, wenn diese erkaltet ist. In diesem Fall beträgt die Vorschubgeschwindigkeit des Trägersubstrats ca. 150 mm/s.

Weiter kann vorgesehen sein, daß die zu übertragende Thermotransferschicht bereichsweise aus unterschiedlichem Material ausgebildet ist und daß das zu übertragende Material durch Positionierung der Trägerfolie und/oder Ansteuerung des Druckkopfes ausgewählt wird.

Die Barriereschicht kann außer dem Schutz vor schädlichen Umwelteinflüssen weitere Aufgaben erfüllen. Die Barriereschicht kann wärmeableitend ausgebildet sein oder Partikel aufweisen, die gegen elektromagnetische Strahlung abschirmen.

Es kann vorgesehen sein, daß die Barriereschicht aus einem thermoplastischen Kunstharz gebildet ist, beispielsweise aus einem Ethylenvinylacetat-Copolymer.

In einer weiteren Ausgestaltung ist vorgesehen, daß die Barriereschicht mit der dem Trägersubstrat abgewandten Oberfläche der Polymerhalbleiterschaltung stoffschlüssig verbunden ist. Die stoffschlüssige Verbindung verhindert das Eindringen von Gasen oder Flüssigkeiten zwischen Barrieereschicht und Oberfläche der Polymerhalbleiterschaltung.

Diese Ausbildung der Verbindung zwischen Barriereschicht und Oberfläche der Polymerhalbleiterschaltung ist besonders vorteilhaft, wenn die mit der Barriereschicht bedeckte Oberfläche der Polymerhalbleiterschaltung eine organische Halbleiterschicht oder eine organische Leiterschicht aufweist. Aber auch metallische Oberflächen können korrosionsanfällig sein, beispielsweise Oberflächen von Silber- oder Aluminiumschichten, die Leiterbahnen bilden können und vorzugsweise mit geringer Schichtdicke ausgebildet sind.

In einer weiteren vorteilhaften Ausgestaltung ist vorgesehen, daß die Barriereschicht partiell ausgebildet ist, beispielsweise Oberflächenbereiche der Polymerhalbleiterschaltung ausspart, bei denen es sich um elektrische Kontakte handelt. Auf diese Weise kann die verkapselte Polymerhalbleiterschaltung besonders einfach mit weiteren Baugruppen verbunden werden, beispielsweise mit einer Antenne oder einer Spannungsquelle. Die Verbindung kann beispielsweise mit leitfähigem Kleber hergestellt sein. Auf diese Weise kann die Polymerhalbleiterschaltung nicht nur in einem sog. Rolle-zu-Rolle-Prozeß hergestellt und verkapselt werden, sondern auch der Weiterverarbeitung zugeführt werden, beispielsweise auf einer Chipkarte oder auf einem Warenetikett plaziert werden.

Es kann sich bei dem offenen Oberflächenbereich aber auch um die Oberfläche eines Sensors handeln, beispielsweise eines Gas- oder Flüssigkeitssensors.

Weiter kann vorgesehen sein, daß die Barriereschicht einen ersten Bereich mit einem ersten Material und mindestens einen zweiten Bereich mit einem zweiten Material aufweist.

Das erste Material und das zweite Material der Barriereschicht können sich beispielsweise in ihrer Transparenz und/oder in ihrer Färbung unterscheiden.

Auf diese Weise können beispielsweise OLED (organische Lichtemitterdioden) unter transparenten Bereiche angeordnet sein und die übrigen Bereiche lichtundurchlässig ausgebildet sein.

Im folgenden wird die Erfindung anhand von mehreren Ausführungsbeispielen unter Zuhilfenahme der beiliegenden Zeichnungen beispielhaft verdeutlicht.

Es zeigen
- Fig. 1: eine schematische Schnittdarstellung eines Ausführungsbeispiel einer Polymerhalbleiterschaltung;
- Fig. 2: eine schematische Schnittdarstellung eines ersten Ausführungsbeispiels mit einer Barriereschicht auf der in Fig. 1 dargestellten Polymerhalbleiterschaltung;
- Fig. 3: eine schematische Schnittdarstellung eines zweiten Ausführungsbeispiels mit einer Barriereschicht auf der in Fig. 1 dargestellten Polymerhalbleiterschaltung;
- Fig. 4: eine schematische Schnittdarstellung eines dritten Ausführungsbeispiels mit einer Barriereschicht auf der in Fig. 1 dargestellten Polymerhalbleiterschaltung;
- Fig. 5: eine schematische Darstellung eines Ausschnitts aus einem thermischen Druckkopf;
- Fig. 6: eine schematische Darstellung eines Druckablaufs;
- Fig. 7a,7b: ein erstes Applikationsbeispiel in schematischer Darstellung;
- Fig. 8a,8b: ein zweites Applikationsbeispiel in schematischer Darstellung.

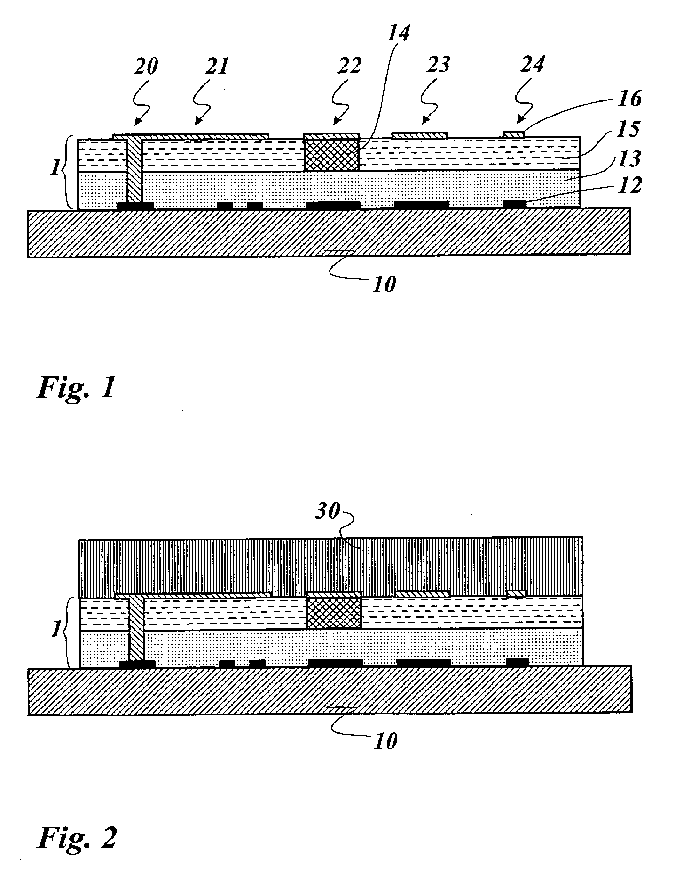

Fig. 1 zeigt ein Ausführungsbeispiel einer Polymerhalbleiterschaltung 1, die auf einer Trägerfolie 10 durch schichtweises Drucken gebildet ist. Die Polymerhalbleiterschaltung 1 weist eine untere leitfähige Schicht 12, eine erste Halbleiterschicht 13, eine zweite Halbleiterschicht 14, eine dielektrische Schicht 15 und eine obere leitfähige Schicht 16 auf. Mit Hilfe der genannten Schichten sind ein Feldeffekttransistor 21, eine Diode 22, ein Kondensator 23 und ein Widerstand 24 gebildet, die durch Verbindungsleitungen miteinander verbunden sind und auf diese Weise die Polymerhalbleiterschaltung 1 bilden.

In Fig. 1 sind eine vertikale Verbindungsleitung und eine waagerechte Verbindungsleitung beispielhaft dargestellt. Die vertikale Verbindungsleitung ist als eine zwischen der oberen leitfähigen Schicht 16 und der unteren leitfähigen Schicht 12 verlaufende Durchkontaktierung 20 ausgebildet. Die waagerechte Verbindungsleitung setzt die Gate-Elektrode des Feldeffekttransistors 21 fort und verbindet diese mit der Durchkontaktierung 20.

In der unteren leitfähigen Schicht 12 sind die Drain- und Source-Elektroden des Feldeffekttransistor 21 ausgeformt.

Die Diode 22 ist aus den übereinander angeordneten Halbleiterschichten 13 und 14 gebildet, die einen unterschiedlichen Leitungstyp aufweisen können, wobei in der Grenzschicht zwischen den beiden Halbleiterschichten oder zwischen Halbleiterschicht und leitfähiger Schicht die für Dioden typische Ventilwirkung ausgebildet ist. Die Halbleiterschichten 13 und 14 stehen an ihren von der Grenzschicht abgewandten Flächen mit der unteren leitfähigen Schicht 12 bzw. mit der oberen leitfähigen Schicht 16 in elektrischem Kontakt.

Der Kondensator 23 wird im wesentlichen von Bereichen der unteren leitfähigen Schicht 12, der oberen leitfähigen Schicht 16 und der dielektrischen Schicht 15 gebildet. Dabei hängt die Kapazität des Kondensators 23 von der Flächengröße der dem Kondensator 23 zugeordneten Bereiche der leitfähigen Schichten 12 und 16, dem Abstand dieser Schichten und der Dielektrizitätskonstante der dielektrischen Schicht 15 ab.

Der Widerstand 14 kann sowohl in der oberen leitfähigen Schicht oder in einer Leiterbahn oder in der unteren leitfähigen Schicht realisiert sein und wird durch den spezifischen Widerstand dieser Materialien sowie durch länge, Breite und Schichtdicke bestimmt.

Sämtliche Schichten der Polymerhalbleiterschaltung 1 sind durch Drucken, Aufsprühen oder Sputtern herstellbar, wobei es sich bis auf eine Schicht auch um metallische oder andere anorganische Schichten handeln kann.

Bei der Trägerfolie 10 kann es sich beispielsweise um eine Kunststoffolie aus Polyethylen, Polypropylen, Polyethylenterephthalat, Polyvinylchlorid etc. in einer Dicke von 12 bis 35 µm handeln, die u.a. auch als Heißprägefolien verwendet werden.

Fig. 2 zeigt nun ein erstes Ausführungsbeispiel mit einer Barriereschicht 30 auf der in Fig. 1 dargestellten Polymerhalbleiterschaltung 1. Die Barriereschicht 30 überdeckt die Oberseite der Polymerhalbleiterschaltung 1 vollständig und schützt sie auf diese Weise vor äußeren Einflüssen. Bei der Barriereschicht 30 handelt es sich um eine Thermotransferschicht, die wie weiter unten beschrieben mittels eines thermischen Druckverfahrens übertragbar ist. Die Thermotransferschicht ist als eine von einer Trägerfolie abziehbare Schicht aus thermoplastischem Material ausgebildet. Bei der Trägerfolie kann es sich um eine PET ( Polyethylenterephthalat)-Folie mit einer Dicke zwischen 4 µm und 12 µm handeln. Zwischen der Thermotransferschicht und der Trägerfolie kann eine Trennschicht aus Wachs angeordnet sein.

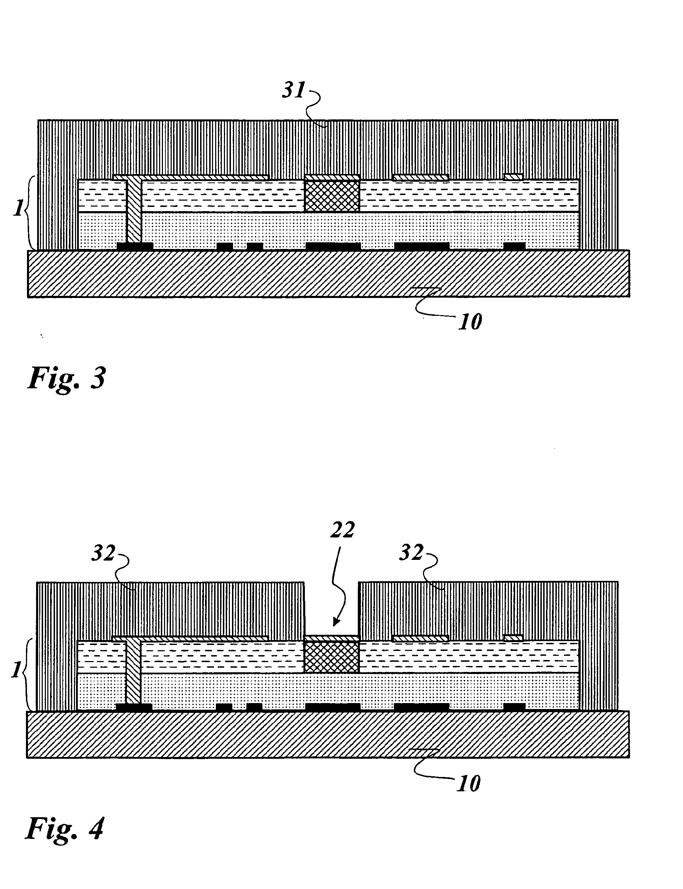

Fig. 3 zeigt ein zweites Ausführungsbeispiel mit einer Barriereschicht 31 auf der in Fig. 1 dargestellten Polymerhalbleiterschaltung 1. Die Barriereschicht 31 überdeckt außer der Polymerhalbleiterschaltung 1 auch den der Polymerhalbleiterschaltung 1 benachbarten Bereich der Trägerfolie 10. Wegen der nichtmaßstäblichen Darstellung in Fig. 3, die insbesondere die Dickenverhältnisse der einzelnen Schichten stark überhöht wiedergibt, ist die Barriereschicht 31 insbesondere in ihren Randbereichen scheinbar mit unterschiedlicher Schichtdicke ausgebildet. Tatsächlich paßt sich die Barriereschicht 31 den äußeren Konturen der Polymerhalbleiterschaltung 1 an und umschließt diese vollständig, denn sie ist aus der in dem thermischen Druckverfahren übertragenen Thermotransferschicht gebildet, die bis zum Schmelzpunkt erwärmte wurde. Wegen der hohen Druckerauflösung, die i.a. etwa 300 dpi (dots per inch) beträgt, ist die Barriereschicht 31 wie auch die in Fig. 2 dargestellte Barriereschicht 30 mit hoher Kantenschärfe ausbildbar.

Fig. 4 zeigt nun ein drittes Ausführungsbeispiel mit einer Barriereschicht 32 auf der in Fig. 1 dargestellten Polymerhalbleiterschaltung 1. In Fig. 4 ist beispielhaft dargestellt, daß die Barriereschicht 32 einen oder mehrere offene Bereiche 32o aufweisen kann, in denen Bereiche der darunter angeordneten Polymerhalbleiterschaltung 1 zugänglich sind. In dem in Fig. 4 dargestellten Ausführungsbeispiel handelt es sich um die obere Elektrode der in Fig. 1 dargestellten Diode 22, wodurch die Diode 22 beispielsweise mit einer Antenne verbindbar ist, die im Zusammenwirken mit der Diode 22 eine Versorgungsspannung für die Polymerhalbleiterschaltung 1 bereitstellen kann, wenn die Antenne einem elektromagnetischen Wechselfeld ausgesetzt wird und auf diese Weise eine elektrische Spannung in der Antenne induziert wird. Eine solche Schaltungsanordnung kann beispielsweise für einen sog. RFID-Tag vorgesehen sein, mit dessen Hilfe Waren oder Sicherheitsdokumente fälschungssicher gekennzeichnet werden können.

Die in Fig. 2 bis 4 dargestellten Ausführungsbeispiele können auch vorsehen, die Barriereschichten 30, 31, 32 mehrfarbig zu gestalten, beispielsweise mit Mustern oder alphanumerischen Zeichen zu versehen. Es kann also vorgesehen sein, die Barriereschichten in die graphische Gestaltung eines mit der Polymerhalbleiterschaltung 1 versehenen Objektes, wie etwa einer Chipkarte, einzubeziehen und/oder die Barriereschichten als Sicherheitsmerkmal zu nutzen. Die Barriereschicht 30, 31, 32 ist ohne Zerstörung der Polymerhalbleiterschaltung 1 und/oder der Barriereschicht selbst nicht ablösbar. Sie kann sich auch über die gesamte Trägerschicht 10 erstrecken oder über ein Trägersubstrat, auf das die Trägerschicht 10 beispielsweise mittels einer Kleberschicht aufgebracht ist. Analog zu dem in Fig. 4 dargestellten Ausführungsbeispiel kann die Barriereschicht 32 weitere offene Bereiche 32o aufweisen, die beispielsweise den Blick auf diffraktive Sicherheitsmerkmale oder Schmuckelemente freigeben, so daß die Ausbildung und Lage der Barriereschicht 32 keinen Rückschluß auf das Vorhandensein, die Ausdehnung und/oder Lage der Polymerhalbleiterschaltung 1 zuläßt.

Es kann weiter vorgesehen sein, auf die Barriereschichten 30, 31, 32 eine weitere aus einer Thermotransferschicht ausgebildete Barriereschicht aufzubringen, beispielsweise um die weiter oben beschriebene Antenne abzudecken und dem Blick zu verbergen. Es kann sich dabei auch um eine Barriereschicht handeln, die personalisierte Daten wiedergibt.

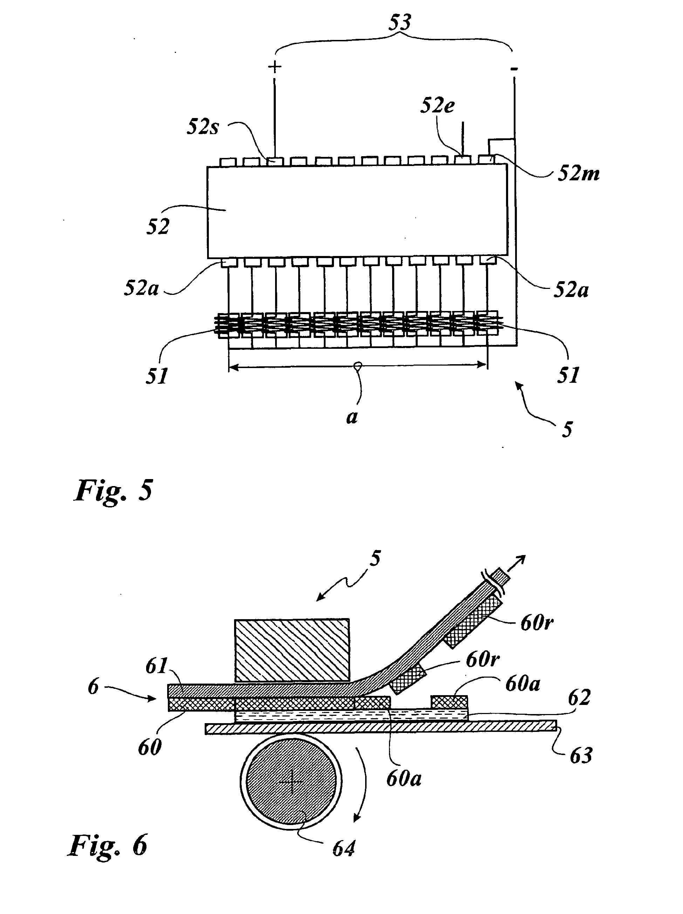

Die Fig. 5 und 6 verdeutlichen nun die Wirkungsweise der Übertragung der Thermotransferschicht auf die zu schützende Oberfläche der Polymerhalbleiterschaltung oder eine andere Fläche, wie die Trägerfolie 10 bzw. ein darunter angeordnetes Trägersubstrat.

Fig. 5 zeigt in unmaßstäblicher schematischer Darstellung einen Ausschnitt aus einem thermischen Druckkopf 5, der pro Millimeter zwölf in einer Zeile angeordnete Heizelemente 51 aufweist. Zur Verdeutlichung der Größenverhältnisse ist in Fig. 5 die Strecke von 1 mm mit "a" bezeichnet.

Der in Fig. 5 ausschnittweise dargestellte Druckkopf 5 vermag also mit einer Auflösung von 12 x 25,4 = 305 dpi zu drucken.

Jedes Heizelement 51 des Druckkopfes 5 ist einzeln ansteuerbar, wobei in dem in Fig. 5 dargestellten Beispiel dazu ein Ansteuerschaltkreis 52 vorgesehen ist, der Ausgangspins 52a, einen Stromversorgungspin 52s, einen Massepin 52m sowie einen Eingangspin 52e aufweist. Die Ausgangspins 52a des Ansteuerschaltkreises 52 sind jeweils mit einem ersten Anschluß der Heizelemente 51 verbunden. Die zweiten Anschlüsse der Heizelemente 51 sind mit der Masseleitung einer Spannungsquelle 53 verbunden, an die auch der Massepin 52m des Ansteuerschaltkreises 52 angeschlossen ist. Der Stromversorgungspin 52s des Ansteuerschaltkreises 52 ist in dem in Fig. 5 dargestellten Beispiel mit dem Pluspol der Spannungsquelle 53 verbunden. Es kann sich bei dem Ansteuerschaltkreis 52 aber auch um einen Schaltkreis handeln, bei dem die Spannungsquelle 53 mit umgekehrter Polarität anschließbar ist.

Wird nun der Eingangspin 52e mit einer geeigneten digitalen Signalfolge angesteuert, verbinden die entsprechenden Ausgangspins 52a die ihnen zugeordneten Heizelemente 51 des Druckkopfes 5 mit dem Pluspol der Spannungsquelle 53, so daß es den in seinem Kontaktbereich angeordneten Bereich der in Fig. 5 nicht dargestellten Thermotransferfolie erhitzt, so daß er auf die zu schützende Oberfläche der Polymerhalbleiterschaltung übertragbar ist.

Fig. 6 verdeutlicht die Übertragung von Abschnitten 60a einer Thermotransferschicht 60 auf eine Polymerhalbleiterschaltung 62. Eine rotierende Transportwalze 64 bringt die Oberfläche der Polymerhalbleiterschaltung 62 in Kontakt mit einem Druckband 6, das aus einer Trägerfolie 61 und einer Thermotransferschicht 60 gebildet ist. Der Druckkopf 5 bildet ein ortsfestes Gegenlager für die Transportwalze 64. Die Thermotransferschicht 60 wird mittels der im einzelnen nicht dargestellten Heizelemente des Druckkopfes 5 partiell erwärmt und auf die Oberfläche der auf einem Trägersubstrat 63 angeordneten Polymerhalbleiterschaltung 62 übertragen. Stromabwärts hinter dem Druckkopf 5 wird die Trägerfolie 61 von der Oberfläche der Polymerhalbleiterschaltung 62 abgezogen, wobei von den Heizelementen des Druckkopfes 5 nicht erwärmte Abschnitte 60r der Thermotransferschicht 60 auf der Trägerfolie 61 verbleiben und auf diese Weise entfernt werden. Die in Fig. 6 dargestellte Anordnung wird auch als Flat-Type-Drucker bezeichnet.

Bei dem Trägersubstrat 63 für die Polymerhalbleiterschaltung 62 kann es sich beispielsweise um eine Polyesterfolie handeln, deren Unterseite eine Kleberschicht aufweist. Es kann sich aber auch um ein relativ starres Trägersubstrat handeln, beispielsweise um eine Plastikkarte handeln.

Wegen der durch die punktweise Übertragung der Thermotransferschicht begrenzten Druckgeschwindigkeit kann vorgesehen sein, die Thermotransferschicht zunächst auf eine Zwischenfolie zu übertragen und von dort im ganzen auf die Polymerhalbleiterschaltung 62. Dieses Druckverfahren wird auch als Thermoretransferdruck bezeichnet.

Das erfindungsgemäße Verfahren ist nicht auf eine bestimmte Ausbildung des thermischen Druckkopfes oder des Thermotransferdruckers bzw. Thermoretransferdruckers beschränkt. Es kann sich also um Flat-Head-, Corner-Edge- oder True-Edge-Drucker handeln. Flat-Head-Drucker sind für die Kaltablösung der Trägerfolie 61 eingerichtet und weisen eine maximale Druckgeschwindigkeit von 150 mm/s auf. Corner-Edge- und True-Edge-Drucker sind für die Heißablösung der Trägerfolie 61 eingerichtet und weisen eine maximale Druckgeschwindigkeit von 300 mm/s auf. Der Vorteil der hohen Druckgeschwindigkeit ist jedoch mit dem Nachteil einer u.U. geringeren Qualität der aufgebrachten Barriereschicht verbunden.

## Patentansprüche

1. Verfahren zur Ausbildung einer Verkapselung für eine auf einem Trägersubstrat (10, 63) angeordnete Polymerhalbleiterschaltung (1, 62),
**dadurch gekennzeichnet,**
**daß** ein Bereich (60a) einer Thermotransferschicht (60) mittels eines thermischen Druckkopfes (5), wie er für den Thermotransferdruck üblich ist und der Heizelemente aufweist, deren Abmessung < 100 µm sind, von einem Druckband (6), das mindestens eine Trägerfolie (61) und die Thermotransferschicht (60) umfaßt, als Barriereschicht (30) auf mindestens die dem Trägersubstrat (10, 63) abgewandte Oberfläche der Polymerhalbleiterschaltung (1, 62) übertragen wird, indem bei der Übertragung ein in einem Kontaktbereich eines Heizelements des thermischen Druckkopfes angeordneter winziger Bereich der Thermotransferschicht (60) aufgeschmolzen und von der Trägerfolie (61) des Druckbandes (6) auf die Oberfläche der Polymerhalbleiterschaltung (1, 62) und unter Verschmelzung von benachbarten übertragenen Bereichen der Thermotransferschicht übertragen wird.

2. Verfahren nach Anspruch 1,
**dadurch gekennzeichnet,**
**daß** die Thermotransferschicht (60) auf die dem Trägersubstrat (10, 63) abgewandte Oberfläche der Polymerhalbleiterschaltung (1, 62) und mindestens auf den an die Polymerhalbleiterschaltung (1, 62) angrenzenden Bereich des Trägersubstrats (10, 63) übertragen wird.

3. Verfahren nach einem der vorhergehenden Ansprüche,
**dadurch gekennzeichnet,**
**daß** die Thermotransferschicht (60) aus einem thermoplastischen Compound, beispielsweise aus einer Mischung von Wachsestern und Ethylenvinylacetat-Copolymeren gebildet ist.

4. Verfahren nach einem der vorhergehenden Ansprüche,
**dadurch gekennzeichnet,**
**daß** die Thermotransferschicht (60) einen Erweichungsbereich von 50 °C bis 80 °C aufweist.

5. Verfahren nach einem der vorhergehenden Ansprüche,
**dadurch gekennzeichnet,**
**daß** die Thermotransferschicht (60) einen Schmelzbereich von 65 °C bis 110 °C aufweist.

6. Verfahren nach einem der vorhergehenden Ansprüche,
**dadurch gekennzeichnet,**
**daß** die Thermotransferschicht (60) in einer Dicke von 1 µm bis 10 µm übertragen wird.

7. Verfahren nach einem der vorhergehenden Ansprüche,
**dadurch gekennzeichnet,**
**daß** die Trägerfolie von der übertragenen Thermotransferschicht (60) abgezogen wird, wenn diese erkaltet ist.

8. Verfahren nach einem der vorhergehenden Ansprüche,
**dadurch gekennzeichnet,**
**daß** ein Druckband (6) verwendet wird, das zwischen der Trägerfolie (61) und der Thermotransferschicht (60) eine Wachsschicht aufweist.

9. Verfahren nach Anspruch 8,
**dadurch gekennzeichnet,**
**daß** die Trägerfolie (61) von der übertragenen Thermotransferschicht (60) abgezogen wird, wenn diese noch heiß ist.

10. Verfahren nach einem der vorhergehenden Ansprüche,
**dadurch gekennzeichnet,**
**daß** die zu übertragende Thermotransferschicht (60) bereichsweise aus unterschiedlichem Material ausgebildet ist und daß das zu übertragende Material durch Positionierung des Druckbandes (6) und/oder Ansteuerung des Druckkopfes (5) ausgewählt wird.

## Claims

1. A method for forming an encapsulation for a polymer integrated circuit (1, 62) arranged on a carrier substrate (10, 63),
**characterised in that**
an area (60a) of a thermal transfer layer (60) is transferred, in the form of a barrier layer (30) and by means of a thermal printhead (5), as is conventional in thermal transfer printing and comprises the heating elements measuring < 100 µm, from a printing tape (6) which comprises at least one carrier film (61) and the thermal transfer layer (60) onto at least the surface of the polymer integrated circuit (1, 62) facing away from the carrier substrate (10, 63) **in that**, during the transfer process, a tiny area of the thermal transfer layer (60) arranged in a contact area of a heating element of the thermal printhead is melted on and is transferred from the carrier film (61) of the printing tape (6) onto the surface of the polymer integrated circuit (1, 62) with fusion of adjacent transferred areas of the thermal transfer layer.

2. The method according to claim 1,
**characterised in that**
the thermal transfer layer (60) is transferred onto the surface of the polymer integrated circuit (1, 62) facing away from the carrier substrate (10, 63) and at least onto the area of the carrier substrate (10, 63) adjacent to the polymer integrated circuit (1, 62).

3. The method according to any one of the preceding claims,
**characterised in that**
the thermal transfer layer (60) is formed of a thermoplastic compound, for example of a mixture of wax esters and ethylene vinyl acetate copolymers.

4. The method according to any one of the preceding claims,
**characterised in that**
the thermal transfer layer (60) has a softening range of 50 °C to 80 °C.

5. The method according to any one of the preceding claims,
**characterised in that**
the thermal transfer layer (60) has a melting range of 65 °C to 110 °C.

6. The method according to any one of the preceding claims,
**characterised in that**
the thermal transfer layer (60) is transferred in a thickness of 1 µm to 10 µm.

7. The method according to any one of the preceding claims,
**characterised in that**
the carrier film is removed from the transferred thermal transfer layer (60) when this has cooled.

8. The method according to any one of the preceding claims,
**characterised in that**
a printing tape (6) is used which comprises a wax layer between the carrier film (61) and the thermal transfer layer (60).

9. The method according to claim 8,
**characterised in that**
the carrier film (61) is removed from the transferred thermal transfer layer (60) when this is still hot.

10. The method according to any one of the preceding claims,
**characterised in that**
the thermal transfer layer (60) to be transferred is formed, in areas, of different material, and **in that** the material to be transferred is selected by positioning the printing tape (6) and/or activating the printhead (5).

## Revendications

1. Procédé de réalisation d'une encapsulation pour un circuit intégré à semi-conducteur polymère (1, 62) disposé sur un substrat porteur (10, 63), **caractérisé en ce qu'**une zone (60a) d'une couche de transfert thermique (60) est déposée en tant que couche barrière (30), au moyen d'une tête d'impression thermique (5) du type de celles couramment utilisées pour l'impression par transfert thermique et présentant des éléments chauffants de taille < 100 µm, à partir d'un ruban d'impression (6) qui comprend au moins un film support (61) et la couche de transfert thermique (60), au moins sur la surface du circuit intégré à semi-conducteur polymère (1, 62) opposée au substrat porteur (10, 63), en faisant fondre lors du transfert une zone infime de la couche de transfert thermique (60) disposée dans une zone de contact d'un élément chauffant de la tête d'impression thermique et en la transférant du film support (61) du ruban d'impression (6) sur la surface du circuit intégré à semi-conducteur polymère (1, 62) avec fusion de zones transférées voisines de la couche de transfert thermique.

2. Procédé selon la revendication 1, **caractérisé en ce que** la couche de transfert thermique (60) est déposée sur la surface du circuit intégré à semi-conducteur polymère (1, 62) opposée au substrat porteur (10, 63) et au moins sur la zone du substrat porteur (10, 63) adjacente au circuit intégré à semi-conducteur polymère (1, 62).

3. Procédé selon l'une des revendications précédentes, **caractérisé en ce que** la couche de transfert thermique (60) est formée à partir d'un composite thermoplastique, par exemple à partir d'un mélange d'esters de cires et de copolymères d'éthylène et d'acétate de vinyle.

4. Procédé selon l'une des revendications précédentes, **caractérisé en ce que** la couche de transfert thermique (60) présente une plage de température de ramollissement de 50°C à 80°C.

5. Procédé selon l'une des revendications précédentes, **caractérisé en ce que** la couche de transfert thermique (60) présente une plage de température de fusion de 65°C à 110°C.

6. Procédé selon l'une des revendications précédentes, **caractérisé en ce que** la couche de transfert thermique (60) est déposée à une épaisseur de 1 µm à 10 µm.

7. Procédé selon l'une des revendications précédentes, **caractérisé en ce que** le film support est détaché de la couche de transfert thermique (60) transférée après que ladite couche a refroidi.

8. Procédé selon l'une des revendications précédentes, **caractérisé en ce que** le ruban d'impression (6) utilisé présente une couche de cire entre le film support (61) et la couche de transfert thermique (60).

9. Procédé selon la revendication 8, **caractérisé en ce que** le film support (61) est détaché de la couche de transfert thermique (60) transférée tandis que ladite couche est encore chaude.

10. Procédé selon l'une des revendications précédentes, **caractérisé en ce que** la couche de transfert thermique (60) à transférer est constituée par zones d'un matériau différent et **en ce que** la sélection du matériau à transférer se fait par le positionnement du ruban d'impression (6) et/ou par la commande de la tête d'impression (5).
